# EUROPÄISCHE PATENTSCHRIFT

(11) **EP 0 891 623 B1**
(45) Veröffentlichungstag und Bekanntmachung des Hinweises auf die Patenterteilung: **16.02.2000**
(21) Anmeldenummer: 97920550.7
(22) Anmeldetag: 26.03.1997
(51) Int. Cl.: G11C 29/00

(54) **SCHALTUNGSANORDNUNG MIT EINER TESTSCHALTUNG**
CIRCUIT ARRANGEMENT WITH A TEST CIRCUIT
MONTAGE AVEC CIRCUIT DE TEST

(30) Priorität: 28.03.1996 DE 19612441
(43) Veröffentlichungstag der Anmeldung: 20.01.1999
(73) Patentinhaber: SIEMENS AKTIENGESELLSCHAFT, 80333 München (DE)
(72) Erfinder: ZETTLER, Thomas, D-81737 München (DE); SOMMER, Diether, D-80469 München (DE); GEORGAKOS, Georg, D-85447 Fraunberg (DE)
(86) Internationale Anmeldenummer: DE9700623
(87) Internationale Veröffentlichungsnummer: WO9737357

(56) Entgegenhaltungen:
- EP-A- 0 146 975
- EP-A- 0 228 283
- EP-A- 0 451 595
- EP-A- 0 480 752

## Beschreibung

Die Erfindung bezieht sich auf eine Schaltungsanordnung nach dem Oberbegriff des Anspruches 1.

Nach der Herstellung einer hochintegrierten Halbleiterschaltung ist es erforderlich, deren dynamischen und statischen Funktionsfähigkeiten zu überprüfen, was für den Hersteller die Durchführung von zumeist aufwendigen Testprozeduren bedeutet. Aufgrund der hohen Zahl aller möglichen logischen Zustände bei den in aller Regel komplexen Schaltungen ist eine umfassende Prüfung der Schaltungen nur mit hohem Zeitaufwand möglich. Da die Testkosten insbesonders bei hochintegrierten Halbleiterspeichern einen wesentlichen Anteil der Produktionskosten darstellen, sind Testverfahren und Testschaltungen erwünscht, welche in kurzer Zeit eine möglichst hohe Fehlerabdeckung gewährleisten. Eine möglichst frühzeitige Aussondierung defekter Schaltungen aus dem Produktionsablauf bringt eine Entlastung der Fertigungsanlagen und trägt so zur Zeit- und Kostenersparnis bei. Gegenwärtig wird eine typische Testfolge speziell für einen elektrisch löschbaren und programmierbaren Halbleiterspeicher (EEPROM) wie folgt verwendet. Vor Beginn der eigentlichen Testfolge werden sämtliche Speicherzellen gelöscht, und anschließend werden entweder alle Speicherzellen oder die nach einem vorbestimmten Muster ausgewählten Speicherzellen auf bestimmte Logikwerte programmiert. Danach kann in der Regel eine sogenannte Streßbehandlung mit erhöhter Temperatur und/oder mit einer überhöhten Drainspannung erfolgen. Bei einem nachfolgenden Testlauf werden die Funktionen der Speicherzellen und Schaltungskomponenten des EEPROMs überprüft, beispielsweise durch Bestimmen der Schwellspannungsverschiebung der Speicherzellen. Nach einem erneuten Löschen cer Speicherzellen wird eine nochmalige Streßbehandlung, gegebenenfalls mit einer erhöhten Gatespannung der Speicherzellen durchgeführt und es wird der Funktionstest unter Bestimmung der Schwellspannungsverschiebung der Speicherzellen wiederholt. Zum Schluß werden die Dateninhalte des EEPROM gelöscht. Bei D. Rhein und H. Freitag, "Mikroelektronische Speicher" Seite 117, Springer-Verlag Wien New York, sind schaltungstechnische Maßnahmen zur Vereinfachung derartiger Prüfprozesse erläutert. Beim sogenannten Gang Programming Mode kann durch paralleles Programmieren von zwei oder vier Bytes die Programmierzeit reduziert werden. Beim sogenannten Full Array Streß Mode werden hohe Streßspannungen an sämtliche Wort- bzw. Bitleitungen gleichzeitig angelegt, um Störungen im normalen Betrieb an den nicht selektierten Zellen nachzubilden. Beim sogenannten individual Cell Threshold Mode arbeiten alle Leseschaltungen mit normaler Betriebsspannung, während an den Wortleitungen die Spannung zwischen Null Volt und der Programmierspannung (typischerweise etwa +18 V) variiert wird, wodurch die individuelle Zelleinsatzspannung bestimmt werden kann. Bei sämtlichen der bisher bekannt gewordenen Tests ist es erforderlich, eine Speicherzelle mehrmals zu programmieren und wieder zu löschen. Dies ist aber gerade bei einem EEPROM sehr zeitaufwendig, und bedingt entsprechend lange Testzeiten, da zum Programmieren bzw. Löschen eines EEPROMs bis zu 50 ms/Byte benötigt werden. Andere aus DRAM-Tests bekannte Algorithmen (beispielsweise der sogenannte March Test) sind aufgrund der hohen Zahl der benötigten Programmierzyklen insbesondere für Flash-EEPROMs nicht einsetzbar.

Aus der DE-A-43 12 238 C2 ist ein Verfahren zum Befreien einer Halbleiterspeichervorrichtung von einem Kurzschluss zwischen benachbarten Speicherzellenauswahlleitungen bekannt geworden, bei dem Fremdmaterial, welches benachbarte Speicherzellenauswahlleitungen kurzschließt, durch Joulesche Wärme weggebrannt wird. Zu diesem Zweck wird von einer elektrischen Quelle eine Überspannung an die Speicherzellenauswahlleitungen angelegt. Aus der Druckschrift ist es bekannt, benachbarte Leitungen auf unterschiedliche Potentiale zu legen und einen Kurzschluß durch Detektion des Leckstromes zu erkennen.

Aus der EP-A-0 480 752 ist eine Schaltungsanordnung nach dem Oberbegriff des Anspruches 1 in Form einer mit einem ROM-Speicher monolithisch integrierten Testschaltung bekannt geworden, die in drei Varianten ausgebildet ist. Bei einer ersten Variante, bei der Wortleitungen getestet werden, werden alle ungeradzahligen Wortleitungen WL1, WL3, usw. mit einem High-Signal von der Testschaltung beaufschlagt, während alle geradzahligen Wortleitungen WL0, WL2, usw. auf Low gesetzt werden. Im Falle eines Kurzschlusses zwischen benachbarten Wortleitungen fließt ein Strom Itw über den Ausgang der Testschaltung, aufgrund welchem ein Defekt in den Wortleitungen erkannt, jedoch nicht lokalisiert werden kann. In einer weiteren Variante ist eine entsprechend arbeitende Testschaltung für die Bitleitungen vorgesehen. Die geradzahligen Bitleitungen werden auf High, die ungeradzahligen Bitleitungen auf Low gesetzt. Durch Messen eines über die Signalleitung für den Signalpfad TEST 1 fließenden Stromes Itb ist es möglich, Kurzschlüsse zwischen benachbarten Bitleitungen festzustellen, jedoch wiederum ohne Lokalisierung der konkreten defekten Bitleitung. In einer weiteren Variante ist schließlich eine Kombination der Testschaltung für die Wortleitungen und der Testschaltung für die Bitleitungen vorgesehen. Sämtliche Varianten der bekannnt gewordenen Testschaltung ermöglichen allerdings nur eine "globale" Ansteuerung der Wort- oder Bitleitungen; eine Lokalisierung einer defekten Signalleitung ist auf diese Weise nicht möglich.

Der vorliegenden Erfindung liegt die Aufgabe zugrunde, eine Schaltungsanordnung der eingangs genannten Gattung anzugeben, welche mit möglichst geringem schaltungstechnischen Mehraufwand ein schnelles und dabei ausreichend aussagekräftiges Testergebnis über die Funktionsfähigkeit der Schaltungsanordnung ermöglicht.

Diese Aufgabe wird durch die Schaltungsanordnung nach Anspruch 1 gelöst.

Der Erfindung liegt die Erkenntnis zugrunde, die in vielen Fällen vorhandene räumliche Symmetrie bzw. reguläre Anordnung einer Vielzahl von strukturell gleichartig angeordneten Elementarschaltungen für einen schaltungstechnisch einfach aufgebauten und mit kurzen Prüfzeiten durchführbaren Durchgangs- und/oder Unterbrechungstest der Gruppenleitungen auszunutzen. In vielen Fällen hat sich herausgestellt, daß ein hoher Anteil herstellungsbedingter Fehler durch Unterbrechungs- und Durchgangstests der Gruppenleitungen ermittelt werden kann. Dadurch werden insbesondere fehlerhafte Gruppenleitungen festgestellt, und ebenso lassen sich die von Elementarschaltungen verursachten, fehlerhaften elektrischen Verbindungen zwischen Gruppenleitungen untereinander und zwischen Gruppenleitungen und anderen Leitungen ermitteln. Durchgangs- und Unterbrechungstests von Gruppenleitungen lassen sich im Gegensatz zu Funktionsüberprüfungen der Elementarschaltungen sehr schnell durchführen. Die mit der erfindungsgemäßen Testschaltung durchführbaren Testläufe ergeben in kürzester Zeit eine hohe Fehlerabdeckung, welche einer effizienten Vorauswahl fehlerhafter Bauteile zugrundegelegt werden kann. Ein wesentlicher Vorteil der Erfindung besteht darin, daß die Testschaltung schaltungstechnisch sehr einfach ausgebildet werden kann und aus nur wenigen zusätzlich auf dem Halbleitersubstrat vorzusehenden Komponenten besteht, so daß die Testschaltung als fester Bestandteil der Halbleiterschaltung auf dem gleichen Halbleitersubstrat integriert ist. In vielen Fällen können ohnehin vorhandene Schaltungsteile der zu testenden Schaltung gleichzeitig fur bestimmte Bestandteile der Testschaltung verwendet werden, so daß die zusätzlich benötigte Fläche der Testschaltung auf dem Halbleitersubstrat gering ist.

Bei einer in Hinblick auf kurze Testzeiten vorteilhaften Weiterbildung der Erfindung kann vorgesehen sein, daß vermittels der den Gruppenleitungen zugeordneten Schalteinrichtung sämtliche geradzahligen Gruppenleitungen mit dem ersten Prüfsignal und sämtliche ungeradzahligen Gruppenleitungen mit dem zweiten Prüfsignal beaufschlagbar sind, und die den Gruppenleitungen zugeordnete Detektionseinrichtung jeweils das von den mit dem ersten bzw. zweiten Prüfsignal beaufschlagten geradzahligen bzw. ungeradzahligen Gruppenleitungen abgeleitete Ausgangssignal erfaßt. Dies ermöglicht, mit nur einem einzigen Test, bei dem zwei verschiedene Prüfsignale an geradzahlige und ungeradzahlige Gruppenleitungen angelegt werden, gleichzeitig eine Vielzahl nebeneinander verlaufender Gruppenleitungen auf Durchgang und Unterbrechung zu prüfen und festzustellen, ob Kurzschlüsse zwischen benachbarten Gruppenleitungen bestehen.

In Weiterbildung der erfindungsgemäßen Schaltungsanordnung kann vorgesehen sein, daß quer zu den Gruppenleitungen eine vorbestimmte Anzahl von nebeneinanderliegend auf dem Halbleitersubstrat ausgebildeten Kollektivleitungen vorgesehen ist, wobei an jeder Kreuzungsstelle von Gruppen- und Kollektivleitungen eine mit der Gruppen- und der Kollektivleitung der jeweiligen Kreuzungsstelle elektrisch gekoppelte Elementarschaltung vorgesehen ist. Vorzugsweise sind die Elementarschaltungen matrixförmig angeordnet, und jeder Gruppen- bzw. Kollektivleitung wird dabei eine Zeile bzw. Spalte der matrixförmigen Anordnung zugeordnet. Dies eröffnet die Möglichkeit, durch Vergleich der Prüfsignale auf den Gruppenleitungen mit denen auf den durch die jeweilige Elementarschaltung mit einer Gruppenleitung verknüpfte Kollektivleitung die Elementarschaltungen auf Durchgang zu prüfen und hierbei Rückschlüsse auf die ordnungsgemäße Funktion der Elementarschaltungen zu ziehen.

Bei einer schaltungstechnisch besonders einfachen Ausgestaltung kann vorgesehen sein, daß eine der Anzahl der Gruppenleitungen entsprechende Zahl von Schaltern vorgesehen ist, welche vermittels eines Auswahlsignals für ein Durchschalten entweder des ersten oder des zweiten Prüfsignals auf eine Gruppenleitung angesteuert sind, wobei die Steuereingänge der den geradzahligen Gruppenleitungen zugeordneten Schalter gemeinsam an eine erste Auswahlleitung und der den ungeradzahligen Gruppenleitungen zugeordneten Schalter gemeinsam an eine zweite Auswahlleitung gekoppelt sind. Die beiden Auswahlleitungen und die jeweils jeder Gruppenleitung zugeordneten Schalter bilden hierbei die einzigen zusätzlich auf dem Halbleitersubstrat auszubildenden Komponenten der Testschaltung. Sowohl die Auswahlleitungen, als auch die Schalter lassen sich in allen gängigen Halbleiter-Technologien (CMOS, TTL, usw.) realisieren. Wird bei den Auswahlleitungen und den Schaltern der Testschaltung die gleiche Halbleiter-Technologie verwendet wie bei den Gruppenleitungen und Elementarschaltungen der zu testenden Schaltung, bleibt der entwicklungs- und produktionstechnische Mehraufwand für die Schalteinrichtung gering.

Um einzelne defekte Gruppenleitungen zu identifizieren, kann vorgesehen sein, daß die Schalteinrichtung eine einzige vorbestimmte Gruppenleitung mit dem ersten Prüfsignal und alle weiteren Gruppenleitungen mit dem zweiten Prüfsignal beaufschlagt. Dieser Test ermöglicht neben der Feststellung eines Kurzschlusses zwischen zwei beliebigen Gruppenleitungen auch die eindeutige Identifikation einer fehlerhaften Gruppenleitung. Zur Identifikation sind hierbei so viele Testläufe erforderlich, wie Gruppenleitungen vorhanden sind. Pro Testlauf wird eine einzige Gruppenleitung mit dem ersten Prüfsignal, alle anderen mit dem zweiten Prüfsignal beaufschlagt.

Für eine besonders schnelle Erkennung von Kurzschlüssen zwischen benachbarten Gruppenleitungen kann vorgesehen sein, daß die Schalteinrichtung jeder Gruppenleitung zugeordnete, von zwei Auswahlleitungen wechselweise angesteuerte und mit der zugeordneten Gruppenleitung ausgangsseitig gekoppelte Schalter aufweist, wobei die den vorbestimmten Gruppenleitungen zugeordneten Schalter eingangseitig an einem ersten Eingangssignal und die den weiteren Gruppenleitungen zugeordneten Schalter eingangsseitig an einem zweiten Eingangssignal liegen, und daß die Detektionseinrichtung eine den geradzahligen Gruppenleitungen zugeordnete erste Detektionsleitung, eine den ungeradzahligen Gruppenleitungen zugeordnete zweite Detektionsleitung und jeder Gruppenleitung zugeordnete, steuereingangseitig mit den Gruppenleitungen elektrisch gekoppelte Detektionsschalter aufweist, wobei die Detektionsschalter eingangsseitig auf einem vorbestimmten konstanten Bezugspotential liegen und ausgangsseitig der Zuordnung an eine geradzahlige bzw. ungeradzahlige Gruppenleitung entsprechend an die erste bzw. zweite Detektionsleitung elektrisch gekoppelt sind, wobei die Detektionseinrichtung eine an die erste Detektionsleitung gekoppelte erste Stromerkennungsschaltung und eine an die zweite Detektionsleitung gekoppelte zweite Stromerkennungsschaltung aufweist. Wenn diese Detektionseinrichtung an den geradzahligen bzw. ungeradzahligen Gruppenleitungen andere als von der Schalteinrichtung an den geradzahligen bzw. ungeradzahligen Gruppenleitungen beaufschlagte Prüfsignale registriert, läßt dies auf mindestens einen Kurzschluß zwischen wenigstens zwei benachbarten Gruppenleitungen oder aber auch auf eine defekte Detektionsleitung schließen.

Bei einer schaltungstechnisch besonders einfachen Realisierung der Schalteinrichtung kann vorgesehen sein, daß die Schalter für das erste und zweite Prüfsignal Schalttransistoren oder mit einem schaltbaren Masseanschluß versehene Inverter darstellen. Diese Bauelemente können ohne zusätzlichen Fertigungsaufwand auf dem Halbleitersubstrat zur Integration der erfindungsgemäßen Testschaltung hergestellt werden.

Bei einer besonders bevorzugten Anwendung der erfindungsgemäßen Schaltungsanordnung kann vorgesehen sein, daß die Elementarschaltungen an den Kreuzungsstellen von Gruppen- und Kollektivleitungen Speicherzellen eines auf dem Halbleitersubstrat ausgebildeten Halbleiterspeichers darstellen. Besonders bei Halbleiterspeichern führen die Durchgangs-, Unterbrechungs und Kurzschlußtests der Gruppenleitungen zu einer Zeitersparnis. Das Programmieren, Löschen und Lesen der Speicherzellen eines Halbleiterspeichers erfordert viel Zeit, insbesondere wenn es sich um einen elektrisch programmierbaren und löschbaren Halbleiterspeicher handelt. Ein dem Stand der Technik entsprechendes Testverfahren dauert dabei bis zu 50 ms/Byte, während die erfindungsgemäßen Tests typischerweise weniger als etwa 50 ns/Byte benötigen, was einem Größenunterschied um den Faktor 10⁶ entspricht.

Für alle Typen von Halbleiterspeichern kann vorgesehen sein, daß die Gruppenleitungen Wort- oder Bitleitungen, die Kollektivleitungen Bit- oder Wortleitungen, die Detektionsleitungen Senseleitungen, die Detektionsschalter die an die Senseleitungen gekoppelten Schalter, die erste und zweite Stromerkennungsschaltung an die Senseleitungen gekoppelte Leseverstärker und die Signalerkennungsschaltungen an die Bitleitungen gekoppelte Leseverstärker darstellen, welche die in einem Halbleiterspeicher ohnehin vorhandenen Schaltungsbestandteile darstellen und in vorteilhafter Weise für die Durchführung eines Test vermittels der erfindungsgemäßen Schaltung herangezogen werden. Dies erfordert bei einem Halbleiterspeicher keinen zusätzlichen schaltungstechnischen Aufwand für die Detektionseinrichtung, für die ausschließlich bereits vorhandene Schaltungskomponenten verwendet werden können.

Von Vorteil können aus den der Auswahlleitung und jeder Wortleitung zugeordneten Transistoren der Schalteinrichtung dem einer Wortleitung zugeordneten, in einem Halbleiterspeicher ohnehin vorhandenen Wortleitungstreiber vorgeschaltet sein. Dadurch können für einen wesentlichen Bestandteil der Schalteinrichtung, welcher die für die Prüfsignale notwendigen Spannungen erzeugt, bereits vorhandene verhältnismäßig aufwendige Einrichtungen genutzt werden.

Der aus Transistoren bestehenden Schalteinrichtung soll ferner eine Wechselschalteinrichtung vorgeschaltet sein, welche eine Auswahlleitung an eine von null verschiedene, vorzugsweise positive Spannung oder an eine Nullspannung koppelt. Dazu kann für die Nullspannung ein bereits vorhandener Masseanschluß und für die positive Spannung beispielsweise die Versorgungsspannung oder eine andere auf dem Halbleitersubstrat verfügbare Spannung verwendet werden.

Bei einer weiteren Ausführung kann vorgesehen sein, daß die an die Bitleitungen gekoppelte Schalteinrichtung die in einem Halbleiterspeicher vorhandene Vorrichtung zum Anlegen der Programmierspannung an die Bitleitungen darstellt. Der schaltungstechnische Mehraufwand für die Testschaltung besteht in diesem Fall lediglich in den beiden Auswahlleitungen bzw. in der Selektions- oder Trennleitung für die gesamte Speichermatrix, sowie einen Transistor bzw. Inverter für jede Gruppenleitung. Alle weiteren Bestandteile der Testschaltung wie Wortleitungstreiber und Programmierspannungserzeuger für die Schalteinrichtung und Leseverstärker und Senseleitungen für die Detektionseinrichtung sind in einer Halbleiterspeichervorrichtung ohnehin vorhanden.

Bei einer bevorzugten Anwendung der erfindungsgemäßen Testschaltung bei einem Test von Halbleiterspeichern, insbesondere von elektrisch programmierbaren und löschbaren Halbleiterspeichern wird vorteilhafter Weise ausgenutzt, daß ein großer Teil der prozeßbedingten Ausfälle auf Metallisierungs- und Polykurzschlüsse sowie Gateoxid-Kurzschlüsse zurückzuführen sind. Die erfindungsgemäße Testschaltung überprüft die oben beschriebenen statischen Verbindungen, ohne Zellen zu programmieren, und ermöglicht damit in kürzester Zeit eine hohe Fehlerabdeckung.

Weitere Merkmale, Vorteile und Zweckmäßigkeiten der Erfindung ergeben sich aus der nachfolgenden Beschreibung von Ausführungsbeispielen anhand der Zeichnung. Es zeigt:
- Figur 1: den schematischen Aufbau einer Speicherzelle eines EEPROMs mit Wort- und Bitleitungen;
- Figur 2: ein schematisches Schaltbild einer Schaltungsanordnung mit einer Testschaltung für einen Wortleitungstest und einen Senseleitungstest eines EEPROMs gemäß einem ersten Ausführungsbeispiel;
- Figur 3A: ein schematisches Schaltbild einer Schaltungsanordnung mit einer Testschaltung für einen Wortleitungstest und einen Senseleitungstest eines EEPROMs gemäß einem zweiten Ausführungsbeispiel;
- Figur 3B: ein schematisches Schaltbild des internen Aufbaus eines in der in Figur 3A dargestellten Schaltungsanordnung enthaltenen Inverters
- Figur 4: ein schematisches Schaltbild einer Schaltungsanordnung mit einer Testschaltung für einen Bitleitungstest eines EEPROMs mit Spannungsleseverstärkern;
- Figur 5: ein schematisches Schaltbild einer Schaltungsanordnung mit einer Testschaltung für einen Bitleitungstest eines EEPROMs mit Stromleseverstärkern; und
- Figur 6: ein schematisches Schaltbild einer Schaltungsanordnung mit einer Testschaltung für einen Bitleitungstest für ein EEPROM mit Stromleseverstärkern.

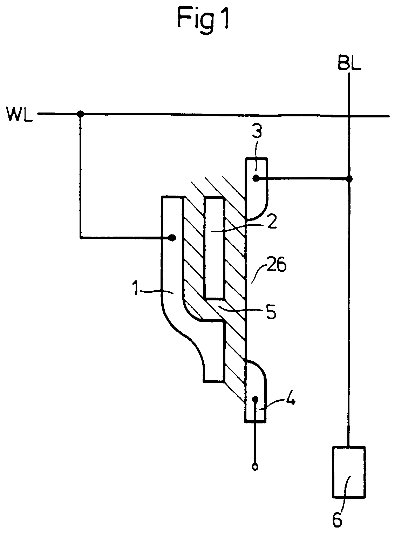

Da bei elektrisch programmierbaren und löschbaren Halbleiterspeichern die erfindungsgemäße Testschaltung besonders vorteilhaft angewendet werden kann, beziehen sich die nachfolgend näher erläuterten Ausführungsbeispiele sämtlich auf elektrisch programmierbare und löschbare Halbleiterspeicher mit OTP- (einmal programmierbaren) oder Flash- (mehrfach programmierbaren Speicherzellen. In Figur 1 ist schematisch eine einzelne Speicherzelle eines elektrisch programmierbaren und löschbaren Halbleiterspeichers dargestellt. Der Anwendungsbereich der erfindungsgemäßen Schaltung ist dabei allerdings nicht auf programmierbare Festwertspeicher oder andere nicht flüchtige Speicher beschränkt, sondern erstreckt sich auch auf beliebig andere Speichertypen und Logikschaltungen mit regelmäßig angeordneten Elementarschaltungen.

Figur 1 zeigt eine Speicherzelle 7 als Beispiel einer Elementarschaltung bestehend aus einer Steuerelektrode 1, einer potentialungebundenen Elektrode 2, einer Drainelektrode 3 und einer Sourceelektrode 4. Die potentialungebundene Elektrode 2 ist von einem Isolator 5 umgeben. Die Steuerelektrode 1 ist an die der der Speicherzelle 7 übergeordneten Zeile zugeordneten Wortleitung WL, die Drainelektrode 3 an die der der Speicherzelle übergeordneten Spalte zugeordneten Bitleitung BL elektrisch gekoppelt. Die Sourceanschlüsse 4 der Speicherzellen sind miteinander gekoppelt und liegen auf einem gemeinsamen, festlegbaren Potential. Diese Speicherzelle funktioniert in an sich bekannter Weise wie folgt. Den beiden Zuständen der Speicherzelle 7 entspricht der geladene und der ungeladene Zustand der potentialungebundenen Elektrode 2. Zum Programmieren werden Ladungen in die potentialungebundene Elektrode 2 injiziert, indem an die Steuerelektrode 1 eine positive Hochspannung gegen die Drainelektrode 3 angelegt wird. Der Wert der positiven Hochspannung liegt typischerweise bei etwa + 18 Volt. Zum Löschen werden Elektronen von der potentialungebundenen Elektrode 2 entfernt, beziehungsweise es werden Löcher in die potentialungebundene Elektrode 2 injiziert, indem eine negative Hochspannung an die Steuerelektrode 1 gegen die Drainelektrode 3 gelegt wird, deren Wert typischerweise bei etwa - 12 Volt liegt. Diese betragsmäßig die Versorgungsspannung übersteigenden Spannungen sind notwendig, um die vom Isolator 5 aufgebaute Potentialbarriere zu überwinden. Aufgrund der hohen elektrischen Feldstärke können Elektronen die Potentialbarriere der Isolatoren durchtunneln ("Fowler-Nordheim-Effect") oder es können in Nähe der Drainelektrode entstandene heiße Elektronen der Isolator überwinden ("Channel-Hot-Elektron-Effect"). Zum Lesen wird eine positive Spannung von etwa 5 Volt zwischen der Steuerelektrode 1 und der Drainelektrode 3 angelegt, die jedoch nicht ausreicht, den Ladungszustand der potentialungebundenen Elektrode 2 zu ändern.

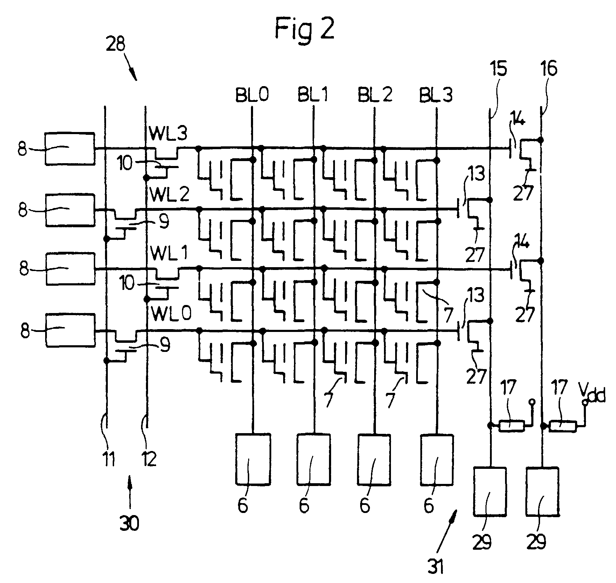

Figur 2 zeigt ein erstes Ausführungsbeispiel einer erfindungsgemäßen Schaltungsanordnung mit einer vorbestimmten Anzahl von auf dem Halbleitersubstrat 26 in regelmäßiger Anordnung nebeneinander ausgebildeten Wortleitungen WL0, WL1, WL2, WL3, welche vorliegend in allgemeiner Form auch als Gruppenleitungen bezeichnet sind, sowie quer zu den Wortleitungen in vorbestimmter Anzahl nebeneinanderliegend auf dem Halbleitersubstrat 26 ausgebildeter Bitleitungen BL0, BL1, BL2, BL3, die vorliegend allgemein auch als Kollektivleitungen bezeichnet sind. An jeder Kreuzungsstelle der Wort- und Bitleitungen ist eine als Elementarschaltung bezeichnete Speicherzelle 7 eines elektrisch programmierbaren und löschbaren Halbleiterspeichers 28 gekoppelt. Zur Ansteuerung der Wortleitungen WL0 bis WL3 sind Wortleitungstreiber 8 vorgesehen, welche in an sich bekannter Weise mit (nicht näher dargestellten) Adressdekoderschaltungen verbunden sind. Zum Auslesen der auf den Bitleitungen BL0 bis BL3 anliegenden Dateninhalte aus den Speicherzellen 7 sind Leseverstärkerschaltungen 6 vorgesehen, deren Aufbau und Wirkungsweise dem Fachmann ebenfalls geläufig ist. Die Wortleitungen WL0 bis WL3 sind über Senseleitungen 15 und 16 über Senseleitungstransistoren 13, 14 mit Leseverstärkern 29 gekoppelt, wobei die Senseleitungen 15 und 16 über eine Spannungsteiler mit dem Widerstand 17 mit der Versorgungsspannung V_{dd} gekoppelt sind, wodurch die Leseverstärker 29 als Stromerkennungsschaltungen arbeiten. Die Wortleitungstreiber 8, Leseverstärkerschaltungen 6, sowie Stromleseverstärkerschaltungen 29 mit den Senseleitungen 15 und 16 sind als Bestandteile eines elektrisch löschbaren und programmierbaren Halbleiterspeichers dem Fachmann geläufige Schaltungsbestandteile, erfordern somit keine nähere Funktionsbeschreibung. Erfindungsgemäß ist eine Schalteinrichtung 30 bestehend aus Schalttransistoren 9 und 10, sowie Auswahlleitungen 11 und 12 vorgesehen, deren Wirkungsweise nachstehend im einzelnen erläutert wird.

Mit dem in Figur 2 dargestellten ersten Ausführungsbeispiel läßt sich folgender Testlauf durchführen. Die geradzahligen Wortleitungen WL0, WL2 werden von den Wortleitungstreibern 8 auf null Volt vorgeladen und durch die Schalttransistoren 9 der Schalteinrichtung 30 abgetrennt. Die ungeradzahligen Wortleitungen WL1, WL3 werden von den Wortleitungstreibern 8 über die Schalttransistoren 10 mit der Lesespannung beaufschlagt. Nur in einer der beiden Senseleitungen 15 oder 16 darf Strom fließen. Wird in beiden Senseleitungen 15 und 16 Strom durch die Stromleseverstärker 29 nachgewiesen, besteht entweder ein Kurzschluß zwischen zwei benachbarten Wortleitungen WL0, ..., WL3, oder es liegt ein Dekoderfehler vor. Wird in keiner der beiden Senseleitung 15, 16 Strom nachgewiesen, ist entweder die Senseleitung 16 unterbrochen, oder es liegt ein Dekoderfehler vor. Der Testlauf wird mit vertauschten Rollen der geradzahligen Wortleitungen WL0, WL2 und der ungeradzahligen Wortleitungen WL1, WL3 wiederholt. Dieser Testlauf gibt also Hinweise auf mögliche Kurzschlüsse zwischen benachbarten Wortleitungen WL0, ..., WL3, Unterbrechungen von Senseleitungen 15, 16 oder Dekoderfehler. Die Kurzschlüsse zwischen benachbarten Wortleitungen WL0, ..., WL3 können beispielsweise Metallisierungs- oder Polykurzschlüsse sein, oder durch die an die Elektroden der Elementarschaltungen angrenzenden Oxidschichten verursacht werden. In diesem Testlauf werden die oben genannten Verbindungen statisch überprüft ohne die Speicherzellen 7 zu programmieren. Dadurch wird in kurzer Zeit eine verhältnismäßig hohe Fehlerabdeckung erreicht.

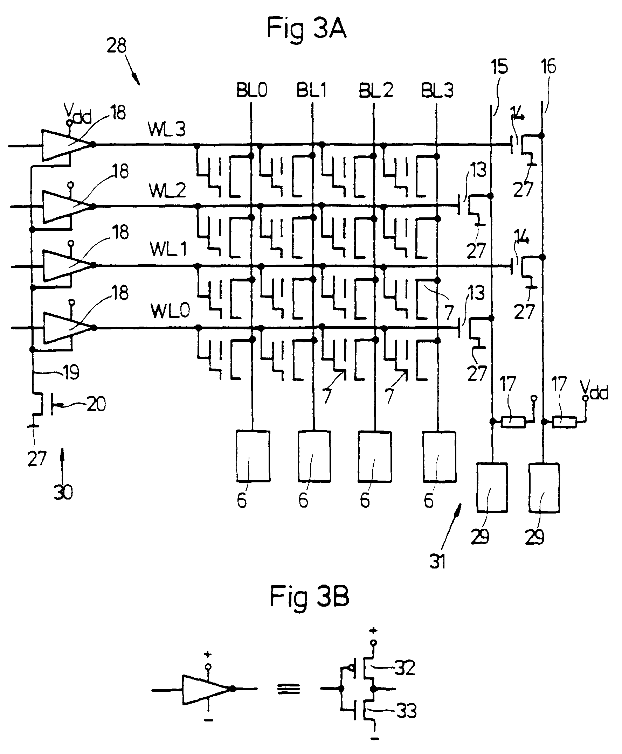

Das in der Figur 3A dargestellte zweite Ausführungsbeispiel einer erfindungsgemäßen Schaltungsanordnung unterscheidet sich vom in Figur 2 dargestellten ersten Ausführungsbeispiel im Aufbau der prüfsignalerzeugenden Schalteinrichtung 30. Anstelle der Schalttransistoren 9, 10 und der Auswahlleitungen 11, 12 weist diese Schalteinrichtung 30 jeweils einer Wortleitung WL0, ..., WL3 zugeordnete Inverter 18 auf, welche ausgangsseitig an die Wortleitungen WL0, ..., WL3 gekoppelt sind. Die Masseanschlüsse der Spannungsversorgungsklemmen der Inverter 18 sind untereinander gekoppelt und über eine Trennleitung 19 und einen als Trennschalter arbeitenden Transistor 20 mit der Masse 27 verbunden. Diese Inverter 18 können in Halbleiterspeichern als Wortleitungstreiber 8 bereits vorhanden sein. Als Detektionseinrichtung 31 werden wie beim zweiten Ausführungsbeispiel die den Bitleitungen BL0, ..., B13 zugeordneten Leseverstärker 6, die Senseleitungen 15, 16, die Senseleitungstransistoren 13, 14 und die jeweils den Senseleitungen 15, 16 zugeordneten, über einen Widerstand 17 an die Versorgungsspannung V_{dd} gekoppelten, als Stromerkennungsschaltung arbeitenden Leseverstärker 29 genutzt. In der Figur 3B ist der interne Aufbau des Inverters 18 dargestellt, welcher aus einer zwischen Versorgungsspannung und Trennleitung geschalteter Reihenschaltung eines p-Kanal-Transistors 32 und eines n-Kanal-Transistors 33 besteht. Der gemeinsame Steueranschluß der Transistoren 32, 33 entspricht dem Eingang des Inverters 18, und gemeinsame Koppelpunkt der Elektroden der Transistoren 32, 33 dem Ausgang des Inverters 18.

Mit dem in den Figuren 3A und 3B dargestellten zweiten Ausführungsbeispiel läßt sich der folgende Testlauf durchführen. Der der Trennleitung 19 zugeordnete Trennschalter 20 ist zunächst leitend, wodurch die beiden Spannungsversorgungsklemmen der Inverter 18 zwischen der Versorgungsspannung V_{dd} und der Masse 27 liegen. Eine Wortleitung WLn wird ausgewählt, und mittels des ihr zugeordneten Inverters 18 mit einer Lesespannung beaufschlagt. Die anderen Wortleitungen WLn' (n'≠n) werden über die ihnen zugeordneten Inverter 18 aktiv auf null Volt getrieben. Nun wird der Trennschalter 20 gesperrt und dadurch alle den Wortleitungen WLn und Wln' zugeordneten Inverter 18 von der Masseversorgung abgetrennt. Dadurch sind die mit null Volt vorgeladenen Wortleitungen WLn' nicht mehr potentialgebunden. Liegt ein Kurzschluß zwischen der ausgewählten Wortleitung WLn und einer benachbarten Wortleitung Wln', wobei n'= n-1 oder n'= n+1 ist, vor, so treibt der der Wortleitung Wln zugeordnete Inverter 18 eine über einen Kurzschluß verbundene benachbarte Wortleitung WLn' auf eine Spannung, welche zwischen der Lesespannung und der Nullspannung liegt. In diesem Fall fließt in beiden Senseleitungen 15, 16 Strom, welcher von den Leseverstärkern 29 nachgewiesen wird. Strom in beiden Senseleitungen 15, 16 kann außer einem Anzeichen für einen Kurzschluß zwischen der ausgewählten Wortleitung WLn und einer benachbarten Wortleitung WLn' auch ein Hinweis auf einen Dekoderfehler sein. Wird in keiner Senseleitung 15 und 16 Strom nachgewiesen, ist die ausgewählte Wortleitung WLn oder eine der Senseleitungen 15 oder 16 unterbrochen, oder es liegt ein Dekoderfehler vor. Nacheinander wird jede Wortleitung WL0, ..., WL3 pro Testlauf als diejenige Wortleitung WLn ausgewählt, welche mit der Lesespannung beaufschlagt wird. Werden auf dem Halbleitersubstrat 26 bereits vorhandene, den Senseleitungen 15, 16 zugeordnete Leseverstärker 29 nicht als Stromleseverstärker ausgeführt und stellen somit keinen Strompfad zur Versorgungsspannung V_{dd} sicher, müssen beispielsweise als Lastelement arbeitende Widerstände oder Transistoren im Widerstandsbetrieb eingeführt werden. Auf diese Weise können auch hochohmige Spannungsleseverstärker als Stromerkennungsschaltungen 29 verwendet werden.

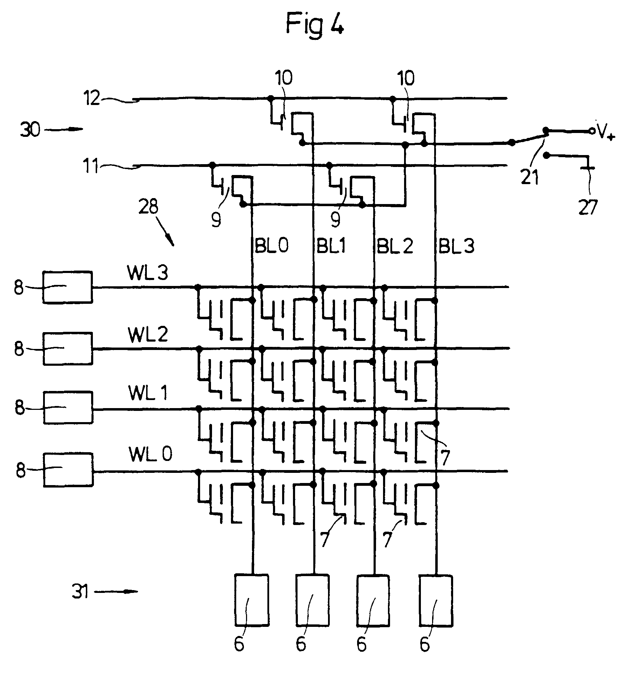

Figur 4 zeigt eine Schaltungsanordnung für einen Bitleitungstest zur Identifikation fehlerhafter Bitleitungen BL0, ..., BL3, welche in diesem und den folgenden Ausführungsbeispielen die Gruppenleitungen darstellen, eines elektrisch programmierbaren und löschbaren Halbleiterspeichers 28 mit als Spannungsdetektoren arbeitenden, an die Bitleitungen BL0, ..., BL3 gekoppelten Leseverstärkern 6, welche die Detektionseinrichtung 31 bilden. Als prüfsignalerzeugende Schalteinrichtung 30 sind jeder Bitleitung BL0, ..., BL3 zugeordnete Schalttransistoren 9, 10 zwischen den Bitleitungen BL0, ..., BL3 und einem zwischen einer vorbestimmten positiven Spannung V₊ und der Masse 27 schaltbaren Wechselschalter 21. Die Steuereingänge der den geradzahligen Bitleitungen BL0, BL2 zugeordneten Schalttransistoren 9 sind miteinander und an die erste Auswahlleitung 11 gekoppelt. Die Steuereingänge der den ungeradzahligen Bitleitungen BL1, BL3 zugeordneten Schalttransistoren 10 sind miteinander und an die zweite Auswahlleitung 12 gekoppelt. Die jeder Bitleitung BL0, ..., BL3 zugeordneten, als Spannungssensor arbeitenden Leseverstärker 6 mit hochohmigem Eingang, welche Detektionseinrichtung 31 bilden, sind auf einem Halbleiterspeicher bereits vorhandenen,

Mit der in Figur 4 dargestellten Anordnung läßt sich der folgende Testlauf durchführen. Der gemeinsame Anschluß der Sourceelektroden 4 aller Speicherzellen 7 und alle Wortleitungen WL0, ..., WL3 liegen während des gesamten Testablaufs auf null Volt. Alle Bitleitungen BL0, ..., BL3 werden durch die Auswahlleitungen 11, 12 angesteuerten Transistoren 9, 10 und den auf die positive Spannung V₊ geschalteten Wechselschalter 21 auf die positive Spannung V₊ vorgeladen. Registriert beim anschließenden Auslesen aller Bitleitungen BL0, ..., BL3 ein Leseverstärker 6 den Null-Volt-Pegel, so ist die entsprechende Bitleitung BL0, ..., BL3 unterbrochen. Danach werden die geradzahligen Bitleitungen BL0, BL2 durch die leitenden Transistoren 9 und den auf Masse 27 geschalteten Wechselschalter 21 auf null Volt gelegt, während die ungeradzahligen Bitleitungen BL1, BL3 durch die sperrenden Transistoren 10 floaten. Beim anschließenden Auslesen aller Bitleitungen BL0, ..., BL3 muß an den Leseverstärkern 6 der geradzahligen Bitleitungen BL0, BL2 der Null-Volt-Pegel und an den Leseverstärkern 6 der ungeradzahligen Bitleitungen BL1, BL3 die vorgeladene positive Spannung V₊ anliegen. Wird an einer ungeradzahligen Bitleitung BL1, BL3 der Null-Volt-Pegel gemessen, so besteht ein Kurzschluß zwischen einer ungeradzahligen Bitleitung BL1, BL3 und einer benachbarten geradzahligen Bitleitung BL0, BL2 oder die betreffende ungeradzahlige Bitleitung BL1, BL3 ist unterbrochen und somit nicht auf die positive Spannung V₊ vorgeladen worden. Der Testablauf wird wiederholt, in dem die geradzahligen Bitleitungen BL0, BL2 und die ungeradzahligen Bitleitungen BL1, BL3 und ihre Rollen vertauschen.

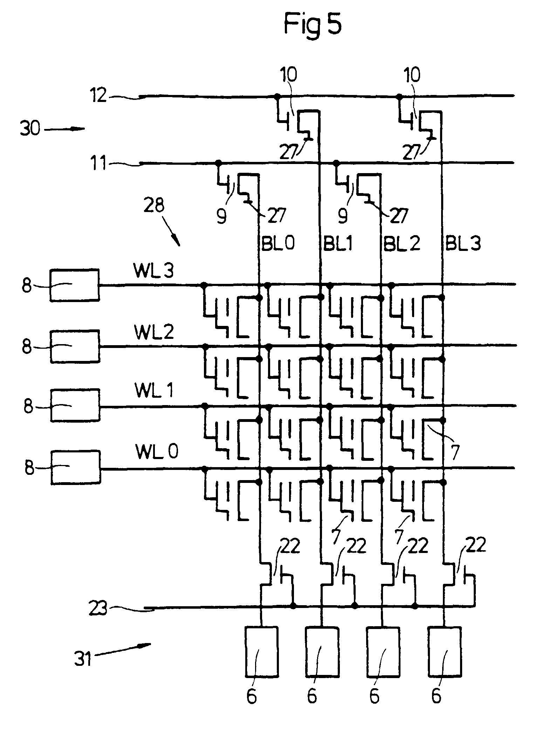

Figur 5 zeigt eine Anordnung, welche im wesentlichen eine Erweiterung der in Figur 4 dargestellten Anordnung ist. Die Leseverstärker 6 arbeiten als Stromsensoren. Zusätzlich sind in jeder Bitleitung BL0, ..., BL3 zwischen den Bitleitungen BL0, ..., BL3 und den Leseverstärkern 6 als Selektionsschalter arbeitende Transistoren 22 zwischengeschaltet. Die Steuereingänge der Selektionsschalter 22 sind miteinander an eine Selektionsleitung 23 gekoppelt.

Mit der in Figur 5 dargestellten Anordnung lassen sich die folgenden vier Testläufe durchführen. Alle Wortleitungen WL0, ..., WL3 und der gemeinsame Anschluß der Sourceelektroden 4 der Speicherzellen 7 liegen bei allen vier Testläufen auf dem Null-Volt-Pegel. Beim ersten Testlauf werden zunächst durch die Selektionsleitung 23 die Selektionsschalter 22 gesperrt und alle Bitleitungen BL0, ..., BL3 abgetrennt und über die Leseverstärker 6 ausgelesen. Wird in einem der Leseverstärker 6 Strom nachgewiesen, so liegt in der entsprechenden Bitleitung BL0, ..., BL3 ein Tunneloxid-Interpolydielektrikum-Durchbruch oder ein beispielsweise durch ein Metallpartikel verursachter direkter Kurzschluß mit einer Wortleitung WL0, ..., WL3 vor. Bei einem zweiten Testlauf werden durch Anlegen der Versorgungsspannung V_{dd} an die Auswahlleitungen 11, 12 alle Bitleitungen BL0, ..., BL3 auf null Volt getrieben und über die Leseverstärker 6 ausgelesen. Wird in einer der Bitleitungen BL0, ..., BL3 kein Strom nachgewiesen, so ist die entsprechende Bitleitung BL0, ..., BL3 unterbrochen. Der dritte Testlauf besteht darin, die geradzahligen Bitleitungen BL0, BL2 auf null Volt zu legen, während die ungeradzahligen Bitleitungen BL1, BL3 potentialungebunden bleiben. Werden alle Bitleitungen BL0, ..., BL3 über die Leseverstärker 6 ausgelesen, müssen die den geradzahligen Bitleitungen BL0, BL2 zugeordneten Leseverstärker 6 Strom nachweisen, und die den ungeradzahligen Bitleitungen BL1, BL3 zugeordneten Leseverstärker 6 dürfen keinen Strom nachweisen. Fließt in einer ungeradzahligen Bitleitung BL1, BL3 Strom, so besteht ein niederohmiger Kurzschluß zwischen zwei Bitleitungen BL0, ..., BL3. Voraussetzung für die Detektion ist, daß die Transistoren 9, 10 der Schalteinrichtung 30 mehr als einen Leseverstärker 6 mit null Volt übertreiben können. Der Nachteil des Testlaufes besteht darin, daß ein hochohmiger Kurzschluß zwischen zwei Bitleitungen BL0, ..., BL3 unter Umständen keinen ausreichenden Strom in der nicht getriebenen Bitleitung BL0, ..., BL3 verursacht und dadurch unerkannt bleibt. Der dritte Testlauf wird wiederholt, indem die geradzahligen und ungeradzahligen Bitleitungen BL0, ..., BL3 ihre Rollen vertauschen. Im vierten Testlauf ermöglichen die als Selektionsschalter arbeitenden Transistoren 22 ein Erkennen eines hochohmigen Kurzschlusses. Zunächst werden alle Bitleitungen BL0, ..., BL3 durch die Schalter 9, 10 von der Masse 27 abgetrennt, und danach über die Leseverstärker 6 auf einen positiven Pegel V₊ getrieben. Nun werden durch ein Sperren der Selektionsschalter 22 die Leseverstärker 6 abgetrennt, wodurch die Ladung auf den Bitleitungen BL0, ..., BL3 erhalten bleibt. Danach werden für eine vorbestimmte Zeit durch Anlegen der Versorgungsspannung V_{dd} an die erste Auswahleitung 11 die geradzahligen Bitleitungen BL0, BL2 aktiv mit null Volt getrieben, während durch Anlegen der Nullspannung an die zweite Auswahleitung 12 die ungeradzahligen Bitleitungen BL1, BL3 potentialungebunden auf dem positiven Pegel V₊ liegen. Während dieser vorbestimmten Zeit kann über einen eventuell vorhandenen hochohmigen Kurzschluß zwischen zwei Bitleitungen BL0, ..., BL3 eine potentialungebundene Bitleitung BL1, BL3 entladen werden. Nach Ablauf der vorbestimmten Zeit werden alle Bitleitungen BL0, ..., BL3 durch geöffnete Selektionsschalter 22 ausgelesen und innerhalb einer kurzen Zeit von den Leseverstärkern 6 wieder abgetrennt. Dies ist notwendig, da eine über einen hochohmigen Kurzschluß entladene Bitleitung BL0, **..,** BL3 sich in kurzer Zeit wieder auf den positiven Pegel V₊ aufladen würde, und der Defekt somit unerkannt bleiben würde. Das Ergebnis der geradzahligen Bitleitungen BL0, BL2 und der ungeradzahligen Bitleitungen BL1, BL3 muß den Zuständen Strom bzw. kein Strom entsprechen. Wird in einer ungeradzahligen Bitleitung BL1, BL3 Strom nachgewiesen, besteht ein Kurzschluß zwischen zwei Bitleitungen BL0, ..., BL3. Der Testablauf wird mit vertauschten Rollen der geradzahligen und ungeradzahligen Bitleitungen BL0, ..., BL3 wiederholt, indem an die erste Auswahlleitung 11 die Nullspannung und an die zweite Auswahlleitung 12 die Versorgungsspannung V_{dd} angelegt werden.

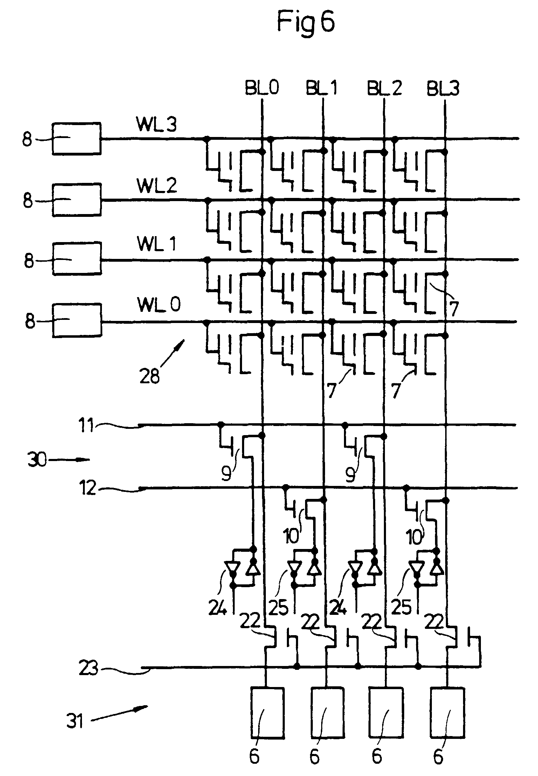

In der Figur 6 ist eine Anordnung dargestellt, bei welchem die prüfsignalerzeugende Schalteinrichtung 30 sich auf der selben Seite der Speichermatrix wie die Detektionseinrichtung 31 befindet. Damit können zwar keine Durchgangstests von Bitleitungen BL0, ..., BL3 durchgeführt werden, aber die Bitleitungen BL0, ..., BL3 können über den Programierpfad mit Spannungen beaufschlagt werden, wodurch Transistoren eingespart werden. Jede Bitleitung BL0, ..., BL3 ist über einen Schalttransistor 9, 10 an eine Latch-Schaltung 24, 25 gekoppelt. Die Leseverstärker 6 arbeiten als Treiber und Stromsensoren und sind damit gleichzeitig Bestandteile der Schalteinrichtung 30 und der Detektionseinrichtung 31. Die Koppelpunkte der den Latch-Schaltungen 24, 25 abgewandten Elektroden der Schalttransistoren 9, 10 auf den Bitleitungen BL0, ..., BL3 liegen zwischen den Selektionsschaltern 22 und den Speicherzellen 7. Die Steuereingänge der den geradzahligen Bitleitungen BL0, BL2 zugeordneten Schalttransistoren 9 sind miteinander an die erste Auswahlleitung 11 gekoppelt. Die Steuereingänge der den ungeradzahligen Bitleitungen BL1, BL3 zugeordneten Schalttransistoren 10 sind an die zweite Auswahlleitung 12 gekoppelt.

Mit der in Figur 6 dargestellten Anordnung lassen sich die folgenden vier Testläufe durchführen. Alle Wortleitungen WL0, ..., WL3 und der gemeinsame Anschluß der Sourceelektroden 4 der Speicherzellen 7 liegen bei allen vier Testläufen auf dem Null-Volt-Pegel. Beim ersten Testlauf werden zunächst durch die Auswahlleitungen 11, 12 die Schalter 9, 10 gesperrt und alle Bitleitungen BL0, ..., BL3 abgetrennt und durch Schließen der Selektionsschalter 22 über die Leseverstärker 6 ausgelesen. Registriert einer der Leseverstärker 6 Strom, so liegt in der diesem Leseverstärker 6 zugeordneten Bitleitung BL0, ..., BL3 ein Tunneloxid-Interpolydielektrikum-Durchbruch oder ein beispielsweise durch ein Metallpartikel verursachter direkter Kurzschluß mit einer Wortleitung WL0, ..., WL3 vor. Bei einem zweiten Testlauf werden durch Anlegen der Nullspannung an die Latch-Schaltungen 24, 25 und die zweite Auswahlleitung 12 und durch Anlegen der Versorgungsspannung V_{dd} an die erste Auswahlleitung 11 die geradzahligen Bitleitungen BL0, BL2 auf null Volt gelegt, während die ungeradzahligen Bitleitungen BL1, BL3 potentialfrei gelegt werden. Werden alle Bitleitungen BL0, ..., BL3 über die Leseverstärker 6 ausgelesen, müssen die den geradzahligen Bitleitungen BL0, BL2 zugeordneten Leseverstärker 6 Strom und die den ungeradzahligen Bitleitungen BL1, BL3 zugeordneten Leseverstärker 6 keinen Strom registrieren. Fließt in einer ungeradzahligen Bitleitung BL1, BL3 Strom, so besteht ein niederohmiger Kurzschluß zwischen zwei Bitleitungen BL0, ..., BL3. Voraussetzung für die Detektion ist, daß die Transistoren 9, 10 der Schalteinrichtung 30 mehr als einen Leseverstärker 6 mit null Volt übertreiben können. Der Nachteil des Testlaufes besteht darin, daß ein hochohmiger Kurzschluß zwischen zwei Bitleitungen BL0, ..., BL3 unter Umständen keinen ausreichenden Strom in der nicht getriebenen Bitleitung BL0, ..., BL3 verursacht und dadurch unerkannt bleibt. Der zweite Testlauf wird wiederholt, indem die geradzahligen und ungeradzahligen Bitleitungen BL0, ..., BL3 ihre Rollen vertauschen. Im dritten Testlauf ermöglicht der als Selektionsschalter arbeitende Transistor 22 ein Erkennen eines hochohmigen Kurzschlusses. Zunächst werden alle Latch-Schaltungen 24, 25 an die Versorgungsspannung V_{dd} gelegt, und durch Sperren der Selektionschalter 22 die Bitleitungen BL0, ..., BL3 von den Leseverstärkern 6 abgetrennt. Danach werden über die Ausgänge der Latch-Schaltungen 24, 25 alle Bitleitungen BL0, ..., BL3 auf die Versorgungsspannung V_{dd} gelegt. Durch Sperren der Schalter 9, 10, 22 werden die Latch-Schaltungen 24, 25 abgetrennt, wobei die Ladung auf den Bitleitungen BL0, ..., BL3 erhalten bleibt. Alle Latch-Schaltungen 24, 25 werden an die Nullspannung gelegt. Jetzt werden für eine vorbestimmte Zeit die geradzahligen Bitleitungen BL0, BL2 aktiv mit null Volt getrieben, während die ungeradzahligen Bitleitungen BL1, BL3 potentialungebunden auf dem positiven Pegel V₊ liegen. Während dieser vorbestimmten Zeit kann über einen eventuell vorhandenen hochohmigen Kurzschluß zwischen zwei Bitleitungen BL0, ..., BL3 eine potentialungebundene Bitleitung BL1, BL3 entladen werden. Nach Ablauf der vorbestimmten Zeit werden alle Bitleitungen BL0, ..., BL3 durch geöffnete Selektionsschalter 22 ausgelesen, und innerhalb einer kurzen Zeit von den Latch-Schaltungen 24, 25 auf die Nullspannunung gelegt. Dies ist notwendig, da die über den hochohmigen Kurzschluß entladene Bitleitleitung BL0, . ., BL3 sich in kurzer Zeit wieder auf den positiven Pegel V₊ aufladen würde, und der Defekt somit unerkannt bleiben würde. Das Ergebnis der geradzahligen Bitleitungen BL0, BL2 und der ungeradzahligen Bitleitungen BL1, BL3 muß den Zuständen Strom bzw. kein Strom entsprechen. Fließt in einer ungeradzahligen Bitleitungen BL1, BL3 Strom, so besteht ein Kurzschluß zwischen zwei Bitleitungen BL0, ..., BL3. Der Testablauf wird mit vertauschten Rollen der geradzahligen und ungeradzahligen Bitleitungen BL0, ..., BL3 wiederholt, indem an die erste Auswahlleitung 11 die Nullspannung und an die zweite Auswahlleitung 12 die Versorgungsspannung V_{dd} angelegt werden.

## Patentansprüche

1. Schaltungsanordnung mit einer vorbestimmten Anzahl von auf einem Halbleitersubstrat (26) in regelmäßiger Anordnung nebeneinander ausgebildeten Gruppenleitungen (WL0, ..., Wlm), an denen eine Vielzahl von auf dem Halbleitersubstrat (26) und im wesentlichen gleichartig zueinander ausgebildeten elektronischen Elementarschaltungen (7) angeschlossen ist, wobei eine Testschaltung zur Überprüfung der elektronischen Funktionsfähigkeit der Elementarschaltungen (7) und/oder der Gruppenleitungen (WL0, ..., Wlm) vorgesehen ist, welche Testschaltung gleichfalls auf dem Halbleitersubstrat (26) der Schaltungsanordnung integriert ausgebildet ist und eine den Gruppenleitungen (WL0, ..., Wlm) zugeordnete Schalteinrichtung (30) aufweist, vermittels welcher wenigstens eine vorbestimmte Gruppenleitung (Wln, BLn) mit einem ersten Prüfsignal und eine weitere, gegenüber der vorbestimmten Gruppenleitung (Wln) unmittelbar benachbart angeordneten Gruppenleitung (Wln', n'=n-1, n'=n+1) mit einem zweiten, gegenüber dem ersten Prüfsignal einen unterschiedlichen Prüfpegel aufweisenden Prüfsignal beaufschlagbar ist, und eine den Gruppenleitungen (WL0, ..., Wlm) zugeordnete Detektionseinrichtung (31) vorgesehen ist, welche ein von den mit dem ersten bzw. zweiten Prüfsignal beaufschlagten Gruppenleitungen (Wln bzw. Wln') abgeleitetes Ausgangssignal erfaßt, und eine der Anzahl der Gruppenleitungen (WL0, ..., Wlm) entsprechende Zahl von Schaltern (9, 10, 18) vorgesehen ist, welche vermittels eines Auswahlsignals für ein Durchschalten entweder des ersten oder des zweiten Prüfsignals auf eine Gruppenleitung (WL0, ..., Wlm) angesteuert sind,
dadurch gekennzeichnet, daß
die Detektionseinrichtung (31) eine den geradzahligen Gruppenleitungen zugeordnete erste Detektionsleitung (15), eine den ungeradzahligen Gruppenleitungen zugeordnete zweite Detektionsleitung (16) und jeder Gruppenleitung (WL0, ..., Wlm) zugeordnete, steuereingangsseitig mit den Gruppenleitungen (WL0, ..., Wlm) elektrisch gekoppelte Detektionsschalter (13, 14) aufweist, wobei die Detektionsschalter eingangsseitig auf einem vorbestimmten konstanten Bezugspotential liegen und ausgangsseitig der Zuordnung an eine geradzahlige bzw. ungeradzahlige Gruppenleitung (WL0, WL2, ... bzw. WL1, WL3,...,) entsprechend an die erste bzw. zweite Detektionsleitung (15 bzw. 16) elektrisch gekoppelt sind.

2. Schaltungsanordnung nach Anspruch 1, dadurch gekennzeichnet, daß vermittels der den Gruppenleitungen (WL0, ..., Wlm) zugeordneten Schalteinrichtung (30) sämtliche geradzahligen Gruppenleitungen(WL0, WL2, ...) mit dem ersten Prüfsignal und sämtliche ungeradzahligen Gruppenleitungen (WL1, WL3, ...) mit dem zweiten Prüfsignal beaufschlagbar sind, und die den Gruppenleitungen (WL0, ..., WLm) zugeordnete Detektionseinrichtung (31) jeweils das von den mit dem ersten bzw. zweiten Prüfsignal beaufschlagten geradzahligen bzw. ungeradzahligen Gruppenleitungen(WL0, WL2, ... bzw. WL1, W13, ...) abgeleitete Ausgangssignal erfaßt.

3. Schaltungsanordnung nach Anspruch 1 oder 2, dadurch gekennzeichnet, daß quer zu den Gruppenleitungen (WL0, ..., Wlm) eine vorbestimmte Anzahl von nebeneinanderliegend auf dem Halbleitersubstrat (26) ausgebildeten Kollektivleitungen (BL0, ..., Blq) vorgesehen ist, wobei an jeder Kreuzungsstelle von Gruppen- und Kollektivleitungen eine mit der Gruppen- und der Kollektivleitung der jeweiligen Kreuzungsstelle elektrisch gekoppelte Elementarschaltung (7) vorgesehen ist.

4. Schaltungsanordnung nach Anspruch 1 bis 3, dadurch gekennzeichnet, daß die Steuereingänge der den geradzahligen Gruppenleitungen (WL0, WL2, ...), zugeordneten Schalter (9) gemeinsam an eine erste Auswahlleitung (11) und der den ungeradzahligen Gruppenleitungen (WL1, WL3, ...) zugeordneten Schalter (10) gemeinsam an eine zweite Auswahlleitung (12) gekoppelt sind.

5. Schaltungsanordnung nach Anspruch 1, dadurch gekennzeichnet, daß die Schalteinrichtung (30) eine einzige vorbestimmte Gruppenleitung (WLn) mit dem ersten Prüfsignal und alle weiteren Gruppenleitungen (WLn', n'≠n) mit dem zweiten Prüfsignal beaufschlagt (Fig. 3A).

6. Schaltungsanordnung nach Anspruch 1 und 2, dadurch gekennzeichnet, daß die Schalteinrichtung (30) jeder Gruppenleitung (WL0, ..., Wlm) zugeordnete, von zwei Auswahlleitungen (11, 12) wechselweise angesteuerte und mit der zugeordneten Gruppenleitung (WL0, WL2, ... oder WL1, WL3, ...) ausgangsseitig gekoppelte Schalter (9, 10) aufweist, wobei die den vorbestimmten Gruppenleitungen (WL1, ..., Wlm) zugeordneten Schalter (9 oder 10) eingangseitig an einem ersten Eingangssignal und die den weiteren Gruppenleitungen (WL1, Wl3, ... oder WL0, Wl2) zugeordneten Schalter (10 oder 9) eingangsseitig an einem zweiten Eingangssignal liegen (Fig. 2).

7. Schaltungsanordnung nach einem der Ansprüche 1 bis 6, dadurch gekennzeichnet, daß die Detektionseinrichtung (31) jeweils eine an die Detektionsleitungen (15, 16) gekoppelte Stromerkennungsschaltung (29) aufweist.

8. Schaltungsanordnung nach einem der Ansprüche 1 bis 7, dadurch gekennzeichnet, daß die Schalter für das erste oder zweite Prüfsignal Schalttransistoren (9, 10) (Fig. 2, 3 , 4, 6) oder mit einem schaltbaren Masseanschluß versehene Inverter (18) (Fig. 3A) darstellen.

9. Schaltungsanordnung nach Anspruch 3 bis 8, dadurch gekennzeichnet, daß die Elementarschaltungen (7) an den Kreuzungsstellen von Gruppen- und Kollektivleitungen (WL0, ...,WLm und BL0, ..., BLm) Speicherzellen (7) eines auf dem Halbleitersubstrat (26) ausgebildeten Halbleiterspeichers darstellen.

10. Schaltungsanordnung nach Anspruch 1 bis 9, dadurch gekennzeichnet, daß die Gruppenleitungen Wort- oder Bitleitungen (WL0, ..., WLm oder BL0, ..., BLm), die Kollektivleitungen Bit- oder Wortleitungen (BL0, ..., BLm oder WL0, ..., WLm), die Detektionsleitungen Senseleitungen (15, 16), die Detektionsschalter die an die Senseleitungen (15, 16) gekoppelten Schalter (13, 14), die erste und zweite Stromerkennungsschaltung an die Senseleitungen gekoppelte Leseverstärker (29) und die Signalerkennungsschaltungen an die Bitleitungen (BL0, ..., BLm) gekoppelte Leseverstärker (6) darstellen.

11. Schaltungsanordnung nach Anspruch 1 bis 10, dadurch gekennzeichnet, daß die den Wortleitungen (WL0, ..., WLm) zugeordnete Schalteinrichtung (30) dem einer Wortleitung (WL0, ..., WLm) zugeordneten und in einem Halbleiterspeicher ohnehin vorhandenen Wortleitungstreiber (8) vorgeschaltet ist.

12. Schaltungsanordnung nach Anspruch 1 bis 11, dadurch gekennzeichnet, daß der Schalteinrichtung (30) eine Wechselschalteinrichtung (21) vorgeschaltet ist, welche eine Auswahlleitung (9, 10) an eine von null verschiedene, vorzugsweise positive Spannung (V₊) oder an eine Nullspannung (27) koppelt.

## Claims

1. Circuit arrangement having a predetermined number of group lines (WL0, ..., Wlm) which are formed next to one another in a regular arrangement on a semiconductor substrate (26) and to which a multiplicity of electronic elementary circuits (7) are connected, which electronic elementary circuits are formed on the semiconductor substrate (26) and such that they are essentially identical to one another, a test circuit for checking the electronic functional capability of the elementary circuits (7) and/or of the group lines (WL0, ..., Wlm) being provided, which test circuit is likewise formed in an integrated manner on the semiconductor substrate (26) of the circuit arrangement and has a switching device (30) which is assigned to the group lines (WL0, ..., Wlm) and by means of which a first test signal can be applied to at least one predetermined group line (Wln, BLn) and a second test signal, which has a different test level compared with the first test signal, can be applied to a further group line (Wln', n'=n-1, n'=n+1) which is arranged such that it is immediately adjacent in relation to the predetermined group line (Wln), and a detection device (31) is provided which is assigned to the group lines (WL0, ..., Wlm) and acquires an output signal derived from the group lines (Wln or Wln') to which the first or second test signal, respectively, has been applied, and a number of switches (9, 10, 18) which corresponds to the number of group lines (WL0, ..., Wlm) are provided and are driven by means of a selection signal for switching either the first or the second test signal through onto a group line (WL0, ..., Wlm), characterized in that the detection device (31) has a first detection line (15), which is assigned to the even-numbered group lines, a second detection line (16), which is assigned to the odd-numbered group lines, and detection switches (13, 14), which are assigned to each group line (WL0, ..., Wlm) and have their control inputs electrically coupled to the group lines (WL0, ..., Wlm), the detection switches being connected, on the input side, to a predetermined, constant reference-earth potential and being electrically coupled, on the output side, to the first or second detection line (15 or 16), respectively, in accordance with the assignment to an even-numbered or odd-numbered group line (WL0, WL2, ... or WL1, WL3, ...,), respectively.

2. Circuit arrangement according to Claim 1, characterized in that the switching device (30) assigned to the group lines (WL0, ..., Wlm) can be used to apply the first test signal to all the even-numbered group lines (WL0, WL2, ...) and the second test signal to all the odd-numbered group lines (WL1, WL3, ...), and the detection device (31) assigned to the group lines (WL0, ..., WLm) in each case acquires the output signal derived from the even-numbered or odd-numbered group lines (WL0, WL2, ... or WL1, W13, ...) to which the first or second test signal, respectively, has been applied.

3. Circuit arrangement according to Claim 1 or 2, characterized in that a predetermined number of collective lines (BL0, ..., Blq) which are formed such that they lie next to one another on the semiconductor substrate (26) is provided transversely with respect to the group lines (WL0, ..., Wlm), there being provided, at each crossover point of group and collective lines, an elementary circuit (7) which is electrically coupled to the group line and to the collective line of the respective crossover point.

4. Circuit arrangement according to Claims 1 to 3, characterized in that the control inputs of the switches (9) assigned to the even-numbered group lines (WL0, WL2, ...) are jointly coupled to a first selection line (11) and the control inputs of the switches (10) assigned to the odd-numbered group lines (WL1, WL3, ...) are jointly coupled to a second selection line (12).

5. Circuit arrangement according to Claim 1, characterized in that the switching device (30) applies the first test signal to a single predetermined group line (WLn) and applies the second test signal to all of the further group lines (WLn', n'≠n) (Figure 3A).

6. Circuit arrangement according to Claims 1 and 2, characterized in that the switching device (30) has switches (9, 10) which are assigned to each group line (WL0, ..., Wlm), are alternately driven by two selection lines (11, 12) and are coupled on the output side to the assigned group line (WL0, WL2, ... or WL1, WL3, ...), the switches (9 or 10) assigned to the predetermined group lines (WL1, ..., Wlm) having a first input signal applied to them on the input side, and the switches (10 or 9) assigned to the further group lines (WL1, W13, ... or WL0, W12) having a second input signal applied to them on the input side (Figure 2).

7. Circuit arrangement according to one of Claims 1 to 6, characterized in that the detection device (31) has a respective current identification circuit (29) coupled to the detection lines (15, 16).

8. Circuit arrangement according to one of Claims 1 to 7, characterized in that the switches for the first or second test signal constitute switching transistors (9, 10) (Figures 2, 3, 4, 6) or invertors (18) provided with a switchable earth connection (Figure 3A).

9. Circuit arrangement according to Claims 3 to 8, characterized in that the elementary circuits (7) at the crossover points of group and collective lines (WL0, ..., WLm and BL0, ..., BLm) constitute memory cells (7) of a semiconductor memory formed on the semiconductor substrate (26) .

10. Circuit arrangement according to Claims 1 to 9, characterized in that the group lines constitute word or bit lines (WL0, ..., WLm or BL0, ..., BLm), the collective lines constitute bit or word lines (BL0, ..., BLm or WL0, ..., WLm), the detection lines constitute sense lines (15, 16), the detection switches constitute the switches (13, 14) which are coupled to the sense lines (15, 16), the first and second current identification circuits constitute sense amplifiers (29) which are coupled to the sense lines, and the signal identification circuits constitute sense amplifiers (6) which are coupled to the bit lines (BL0, ..., BLm).

11. Circuit arrangement according to Claims 1 to 10, characterized in that the switching device (30) assigned to the word lines (WL0, ..., WLm) is connected upstream of the word line driver (8) which is assigned to a word line (WL0, ..., WLm) and is present in any case in a semiconductor memory.

12. Circuit arrangement according to Claims 1 to 11, characterized in that a changeover switching device (21), which couples a selection line (9, 10) to a voltage which is different from zero, preferably a positive voltage (V₊), or to a zero voltage (27), is connected upstream of the switching device (30).

## Revendications

1. Montage comprenant un nombre prédéfini de lignes de groupe (WL0, ..., Wlm) réalisées l'une à côte de l'autre, selon une disposition régulière, sur un substrat semi-conducteur (26), auxquelles est connectée une pluralité de circuits élémentaires (7) électroniques réalisés sur ledit substrat semi-conducteur (26) et essentiellement similaires l'un à l'autre, un circuit de test étant prévu pour contrôler le fonctionnement électronique des circuits élémentaires (7) et/ou des lignes de groupe (WL0, ..., Wlm), lequel circuit de test est lui aussi intégré au substrat semi-conducteur (26) du montage et comporte un dispositif de commutation (30) attribué aux lignes de groupe (WL0, .... Wlm) et susceptible d'appliquer un premier signal d'essai à au moins une ligne de groupe prédéfinie (Wln, BLn) et un second signal d'essai d'un niveau d'essai différent du premier signal à une autre ligne de groupe (Wln', n'=n-1, n'=n+1) directement contiguë à la ligne de groupe (Wln) prédéfinie, et avec un dispositif de détection (31) attribué aux lignes de groupe (WL0,..., Wlm), lequel détecte un signal de sortie déduit des lignes de groupe (Wln resp. Wln') auxquelles est appliqué le premier resp. second signal d'essai, et avec des commutateurs (9, 10, 18) en nombre correspondant au nombre des lignes de groupe (WL0, ..., Wlm), lesquels sont commandés au moyen d'un signal de sélection pour relier soit le premier soit le second signal d'essai à une ligne de groupe (WL0, ..., Wlm), caractérisé en ce que le dispositif de détection (31) comporte une première ligne de détection (15) attribuée aux lignes de groupe paires, une seconde ligne de détection (16) attribuée aux lignes de groupe impaires et des commutateurs de détection (13, 14) attribués à chaque ligne de groupe (WL0, ..., Wlm) et couplés électriquement, côté entrée, aux lignes de groupe (WL0, ..., Wlm), les commutateurs de détection, côté entrée, étant sous un potentiel de référence constant prédéfini et couplés électriquement, côté sortie de l'attribution à une ligne de groupe paire resp. impaire (WL0, WL2, ..., resp. WL1, WL3, ...), à la première resp. seconde ligne de détection (15 resp. 16).

2. Montage selon la revendication 1, caractérisé en ce que le dispositif de commutation (30) attribué aux lignes de groupe (WL0, ..., Wlm) est susceptible d'appliquer le premier signal d'essai à l'ensemble des lignes de groupe paires (WL0, WL2, ...) et le second signal d'essai à l'ensemble des lignes de groupe impaires (WL1, WL3, ...) et en ce que le dispositif de détection (31) attribué aux lignes de groupe (WL0, ..., WLm) détecte à chaque fois le signal de sortie déduit des lignes de groupe paires resp. impaires (WL0, WL2, ... resp. WL1, Wl3) auxquelles est appliqué le premier resp. second signal d'essai.

3. Montage selon la revendication 1 ou 2, caractérisé en ce qu'il comporte un nombre prédéfini de lignes collectives (BL0, ..., Blq) réalisées l'une à côté de l'autre sur le substrat semi-conducteur (26) et perpendiculairement aux lignes de groupe (WL0, ..., Wlm), à chaque point d'intersection de lignes de groupe et de lignes collectives étant prévu un circuit élémentaire (7) couplé électriquement à la ligne de groupe et à la ligne collective du point d'intersection respectif.

4. Montage selon les revendications 1 à 3, caractérisé en ce que les entrées de commande des commutateurs (9) attribués aux lignes de groupe paires (WL0, WL2, ...) sont couplées ensemble à une première ligne de sélection (11) et celles des commutateurs (10) attribués aux lignes de groupe impaires (WL1, WL3, ...) à une seconde ligne de sélection (12).

5. Montage selon la revendication 1, caractérisé en ce que le dispositif de commutation (30) applique le premier signal d'essai à une seule ligne de groupe (WLn) prédéfinie et le second signal d'essai à toutes les autres lignes de groupe (WLn', n'≠n) (fig. 3A).

6. Montage selon les revendications 1 et 2, caractérisé en ce que le dispositif de commutation (30) comporte des commutateurs (9, 10) attribués à chaque ligne de groupe (WL0, ..., Wlm), commandés en alternance par deux lignes de sélection (11, 12) et couplés, côté sortie, à la ligne de groupe attribuée (WL0, WL2, ... ou WL1, WL3, ...), un premier signal d'entrée étant appliqué, côté entrée, aux commutateurs (9 ou 10) attribués aux lignes de groupe (WL1, ..., Wlm) prédéfinies et un second signal d'entrée, côté entrée, aux commutateurs (10 ou 9) attribués aux autres lignes de groupe (WL1, Wl3, . .. ou WL0, Wl2) (fig. 2).

7. Montage selon l'une des revendications 1 à 6, caractérisé en ce que le dispositif de détection (31) comporte à chaque fois un circuit d'identification de courant (29) couplé aux lignes de détection (15, 16).

8. Montage selon l'une des revendications 1 à 7, caractérisé en ce que les commutateurs pour le premier ou le second signal d'essai représentent des transistors de commutation (9, 10) (fig. 2, 3, 4, 6) ou des inverseurs (18) (fig. 3A) pourvus d'une connexion à la masse commutable.

9. Montage selon les revendications 3 à 8, caractérisé en ce que les circuits élémentaires (7) situés aux points d'intersection de lignes de groupe et de lignes collectives (WL0, ..., WLm et BL0, ..., BLm) représentent des cellules de mémoire (7) d'une mémoire à semiconducteurs réalisée sur le substrat semi-conducteur (26).

10. Montage selon les revendications 1 à 9, caractérisé en ce que les lignes de groupe représentent des lignes de mot ou de bit (WL0, ..., WLm ou BL0, . . ., BLm), les lignes collectives des lignes de bit ou de mot (BL0, ..., BLm ou WL0, WLm), les lignes de détection des lignes d'identification (15, 16), les commutateurs de détection les commutateurs (13, 14) couplés aux lignes d'identification (15, 16), le premier et second circuit d'identification de courant des amplificateurs de lecture (29) couplés aux lignes d'identification et les circuits d'identification de signaux des amplificateurs de lecture (6) couplés aux lignes de bit (BL0, ..., BLm).

11. Montage selon les revendications 1 à 10, caractérisé en ce que le dispositif de commutation (30) attribué aux lignes de mot (WL0, ..., WLm) est monté en amont d'un driver de ligne de mot (8) attribué à une ligne de mot (WL0, ..., WLm) et existant de toute façon dans une mémoire à semiconducteurs.

12. Montage selon les revendications 1 à 11, caractérisé en ce qu'en amont du dispositif de commutation (30) est monté un dispositif de commutation alternée (21), lequel applique une tension (V₊) différente de zéro, de préférence positive, ou une tension nulle (27) à une ligne de sélection (9, 10).
